# EUROPÄISCHE PATENTANMELDUNG

(11) **EP 0 887 651 A2**
(43) Veröffentlichungstag der Anmeldung: **30.12.1998**
(21) Anmeldenummer: 98110756.8
(22) Anmeldetag: 12.06.1998
(51) Int. Cl.: G01R 31/08

(54) **Verfahren und Schaltungsanordnung zur Lokalisierung eines Kurzschluss oder Kabelbruchs in einem Bus-System**

(30) Priorität: 23.06.1997 DE 19726539
(71) Anmelder: Daimler-Benz Aktiengesellschaft, 70567 Stuttgart (DE)
(72) Erfinder: Fluhrer, Sven, 73035 Göppingen (DE)

(57) **Zusammenfassung**

Die vorliegende Erfindung betrifft ein Verfahren zur Lokalisierung eines Kurzschluß oder Kabelbruchs in einem Zweidraht-Bus-System, wobei das Zweidraht-Bus-System an wenigstens einem Punkt mit einem Impuls einer solchen Steilheit beaufschlagt wird, daß sich an der Stelle des Kurzschluß bzw. des Kabelbruchs eine Reflexion einstellt und wobei anhand der Laufzeit des Impulses eine Lokalisierung des Kurzschluß oder Kabelbruchs vorgenommen wird. Weiterhin betrifft die Erfindung eine Schaltungsanordnung zur Durchführung eines der vorgenannten Verfahren, wonach ein Impulsgenerator mit einer Gatterkette mit Schieberegister verbunden ist, wonach weiterhin mit der Aussendung eines Impulses auf das Zweidraht-Bus-System der Signaldurchlauf durch die Gatterkette gestartet wird, wonach das reflektierte Signal den Signaldurchlauf durch die Gatterkette abbricht, wobei aus der Anzahl der durchlaufenen Gatter die Entfernung des Kurzschlusses oder Kabelbruchs von dem Ort ermittelt wird, an dem der Impulsgenerator an das Zweidraht-Bus-System angeschlossen ist. Weiterhin wird ein Verfahren zur Lokalisierung eines Kabelbruches vorgeschlagen, wobei auf einen Kabelbruch zu den Verbindungsleitungen eines Teilnehmers geschlossen wird, wenn dieser Teilnehmer bei der Kommunikation über den Bus nicht erreichbar ist.

## Beschreibung

Die vorliegende Erfindung betrifft ein Verfahren und eine Schaltungsanordnung zur Lokalisierung eines Kurzschluß oder Kabelbruchs in einem Bus-System, wonach eine Lokalisierung eines Kurzschluß oder Kabelbruchs in einem Bus-System erfolgt, indem das Bus-System an Wenigstens einem Punkt mit einem Impuls einer solchen Steilheit beaufschlagt wird, daß sich an der Stelle des Kurzschluß bzw. des Kabelbruchs eine Reflexion einstellt und daß anhand der Laufzeit des Impulses eine Lokalisierung des Kurzschluß oder Kabelbruchs vorgenommen wird.

Es ist weiterhin bereits ein Verfahren bekannt, nach dem unter bestimmten Umständen ein Kurzschluß einer oder beider Leitungen eines Zweidraht-Bus-Systems gegen Masse oder das Bordhetzpotential oder ein Kabelbruch einer oder beider Leitungen erkannt werden kann (DE 42 12 742 A1). Danach werden die Spannungspegel auf den beiden Busdrähten mit bestimmten Schwellwerten verglichen. In Abhängigkeit von verschiedenen Fehlern sind dabei verschiedene Paare von Spannungspegeln angegeben, die sich auf den beiden Busdrähten einstellen sollen. Durch eine Auswertung der Spannungspegel soll also auf die Art des Fehlers rückgeschlossen werden können.

Erfindungsgemäß ist es aus der DE-Z: ntz, Bd. 47 (1994) Heft 4, S. 242-246 bekannt, eine Leitungslänge bzw. einen Fehlerort eines Bus-Systemes durch eine Laufzeitmessung eines reflektierten Signales vorzunehmen, das an einem Ende in die Leitung des Bus-Systems eingeprägt wird.

Ebendies ist auch aus der DE 37 12 780 A1 bekannt, bei der die Laufzeitmessung erfolgt, indem in einem bestimmten Zeitabstand nach dem Empfang des reflektierten Signales erneut ein Impuls ausgesendet wird. Es wird die Frequenz der Impulse gemessen, aus der die Laufzeit ermittelt werden kann. Dabei werden Impulse mit abwechselnd alternierendem Vorzeichen erzeugt.

Aus der US-PS 4,151,459 ist es im Zusammenhang mit der Fehlersuche einer Leine eines Skiliftes bekannt, eine Laufzeitmessung eines Signales vorzunehmen, das in die Leine des Skiliftes eingeprägt wird. Die Laufzeitmessung erfolgt unter Verwendung eines Schieberegisters.

Mittels dieser Verfahrens läßt sich die Entfernung des Kurzschlusses bzw. Kabelbruchs von dem Ort ermitteln, an dem das Bus-Ssytem mit dem Impuls beaufschlagt wurde. Bei Kenntnis der Netztopologie läßt sich mittels dieses-Verfahrens eine lokale Eingrenzung des Fehlers vornehmen.

Demgegenüber ist es die Aufgabe der vorliegenden Erfindung, die Lokalisierung eines erkannten Fehlers zu verbessern.

Erfindungsgemäß gelöst wird diese Aufgabe durch ein Verfahren nach Anspruch 1, wonach das Bus-System ein Zweidraht-Bus-System ist, das bei einem erkannten Kurzschluß nach Masse mit einem positiven Impuls und bei einem erkannten Kurzschluß nach dem Netzpotential mit einem negativen Impuls beaufschlagt wird.

Durch diese Wahl der Impulse stellt sich die zur Auswertung erforderliche Reflexion des Impulses ein. Durch die vorangegangene Fehleranalyse ist es bekannt, ob es sich um einen Kurzschluß nach Masse oder nach dem Netzpotential handelt, so daß also in Abhängigkeit von dieser Auswertung das Vorzeichen des Impulses gewählt werden kann. Die vorangegangene Fehleranalyse kann beispielsweise nach dem eingangs beschriebenen Verfahren erfolgen oder nach dem Verfahren, das in der Anmeldung der Anmelderin mit demselben Anmeldetag beschrieben worden ist, die unter dem Aktenzeichen 197 26 538.3 beim deutschen Patentamt anhängig ist.

Bei dem Verfahren nach Anspruch 2 ist der Impuls zumindest näherungsweise ein Dirac-Stoß.

Dadurch wird einerseits eine hinreichende Flankensteilheit erreicht, so daß sich eine Reflexion einstellt. Andererseits wird sichergestellt, daß der Energieinhalt des Impulses auf einen endlichen Wert beschränkt ist, so daß durch die Überprüfung bedingte Fehler vermieden werden können.

Bei der Schaltungsanordnung nach Anspruch 3 zur Durchführung eines der vorgenannten Verfahren ist ein Impulsgenerator mit einer Gatterkette mit Schieberegister verbunden, wobei mit der Aussendung eines Impulses auf das Zweidraht-Bus-System der Signaldurchlauf durch die Gatterkette gestartet wird, wobei weiterhin das reflektierte Signal den Signaldurchlauf durch die Gatterkette abbricht, wobei aus der Anzahl der durchlaufenen Gatter die Entfernung des Kurzschlusses oder Kabelbruchs von dem Ort ermittelt wird, an dem der Impulsgenerator an das Zweidraht-Bus-System angeschlossen ist, wobei von dem Impulsgenerator bei einem erkannten Kurzschluß nach Masse ein positiver Impuls ausgesendet wird und bei einem erkannten Kurzschluß nach dem Netzpotential ein negativer Impuls.

Mit dieser Schaltungsanordnung läßt sich das erfindungsgemäße Verfahren vergleichsweise einfach durchführen.

Bei einem Verfahren zur Lokalisierung eines Kabelbruches nach Anspruch 4 wird auf einen Kabelbruch zu den Verbindungsleitungen eines Teilnehmers geschlossen, wenn dieser Teilnehmer bei der Kommunikation über den Bus nicht erreichbar ist.

Dadurch kann auch dieser Fehlerfall erkannt werden, während ansonsten durch die unterbrochene Kommunikation dieser Fehlerfall nicht erkannt werden kann.

Ein Ausführungsbeispiel der Erfindung ist in der Zeichnung näher dargestellt. Es zeigt dabei im einzelnen:

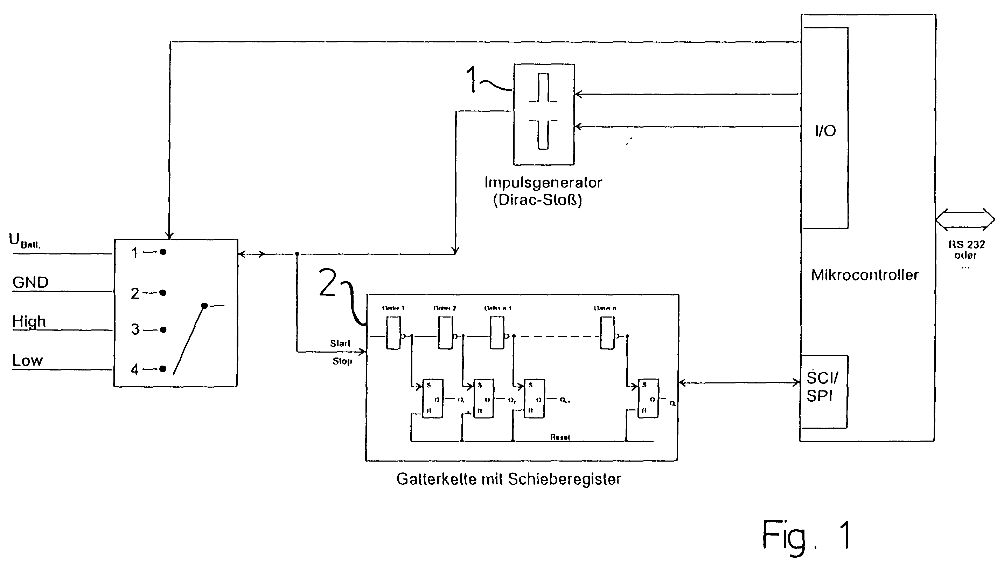

- Fig. 1:: ein Ausführungsbeispiel der Schaltungsanordnung und
- Fig. 2 - 4:: eine Prinzipdarstellung, wie unter Kenntnis der Bustopologie eine lokale Eingrenzung des Fehlers vorgenommen werden kann.

Allgemein sind die Kurschluß- und Kabelbruchfehler im wesentlichen in zwei Gruppen einzuteilen:
1. Kurzschluß nach der Bordnetzspannung und
2. Kurzschluß nach Masse oder gegeneinander bzw. Kabelbruch.
Entscheidend für die Messung ist, daß für die erste Gruppe ein negativer Impuls benötigt wird und für die zweite Gruppe ein positiver Impuls. Das Prinzip der Leitungsreflexion setzt eine entsprechend ausgebildete Flankensteilheit voraus (Dirac-Stoß).

Je nach der Art des ermittelten Fehlers wird die relevante Leitung mit der Laufzeitermittlungsschaltung verbunden. Hierzu wird auf eine der relevanten Leitungen ein Dirac-Impuls von dem Impulsgenerator 1 eingeprägt (High- oder Low-Leitung). Gleichzeitig wird dadurch eine Gatterkette 2 getriggert und der Prüf-Start für das Shiftregister ausgelöst. An der Fehlerstelle im Netzwerk wird der Impuls reflektiert und kommt auf der gleichen Leitung wieder zurück. Dieser reflektierte Impuls stoppt den Signaldurchlauf durch die Gatterkette, wobei die Anzahl der gesetzten Flip-Flops (Shiftregister) gleich der Anzahl der durchlaufenen Gatter ist. Somit ist die Anzahl der gesetzten Flip-Flops multipliziert mit der Durchlaufzeit eines Gatters die Gesamtaufzeit des Impulses auf der fehlerhaften Leitung. Dieser ermittelte Zeitwert dividiert durch zwei entspricht der Entfernung des Fehlerortes zum Prüfgerät. Wird die Signallaufzeit auf einer Leitung mit 5 ns pro Meter angenommen und werden beispielsweise Gatter verwendet, deren Durchlaufzeit 2,5 ns beträgt, so kann der Fehlerort mit einer Auflösungsgenauigkeit in der Größenordnung von 0,5 m bestimmt werden. Diese Auflösungsungenauigkeit hängt damit zusammen, daß für die Zeit zwischen zwei Gatterdurchläufen keine Aussage möglich ist, ob gerade ein Gatterdurchlauf beendet worden ist oder ob der nächste Gatterdurchlauf unmittelbar bevorsteht. Daraus resultiert eine Ungenauigkeit in der Größenordnung von einem Gatterdurchlauf, d.h. 2,5 ns. Daraus resultiert unter der angenommen Signallaufzeit auf der Leitung von 5 ns pro Meter eine Ortsungenauigkeit von 0,5 m. Generell ist die Ortsungenuigkeit um so geringer, je kürzer die Gatterlaufzeit ist. Werden beispielsweise Gatter mit einer Durchlaufzeit von 0,4 ns verwendet, resultiert daraus eine theoretische Ortsungenuigkeit von 8 cm.

Mit Kenntnis der jeweiligen Netztopologie und bei Bedarf auch mehreren Messungen an verschiedenen Orten des Netzes zur Eingrenzung des Fehlers kann der mögliche Fehlerort auf eine oder zwei Stellen im Netzwerk eingegrenzt werden.

Zur Lokalisierung eines doppelten Drahtabrisses ist zusätzlich zu dem entsprechenden Protokollbaustein auch die Kenntnis der Soll- und Istkonfiguration des Netzes notwendig. Wird ein bestimmter Netzknoten nie detektiert, obwohl er eigentlich am Netz teilnehmen sollte, muß ein Kabelbruch vorliegen und somit kann dieser Netzknoten eindeutig bestimmt werde. In diesem Fall liegt ein Defekt der Stichleitung zu diesem Steuergerät vor. Die genaue Lokalisierung des doppelten Kabelbruches kann ebenfalls, wie oben beschrieben, nach dem Reflexionsverfahren ermittelt werden.

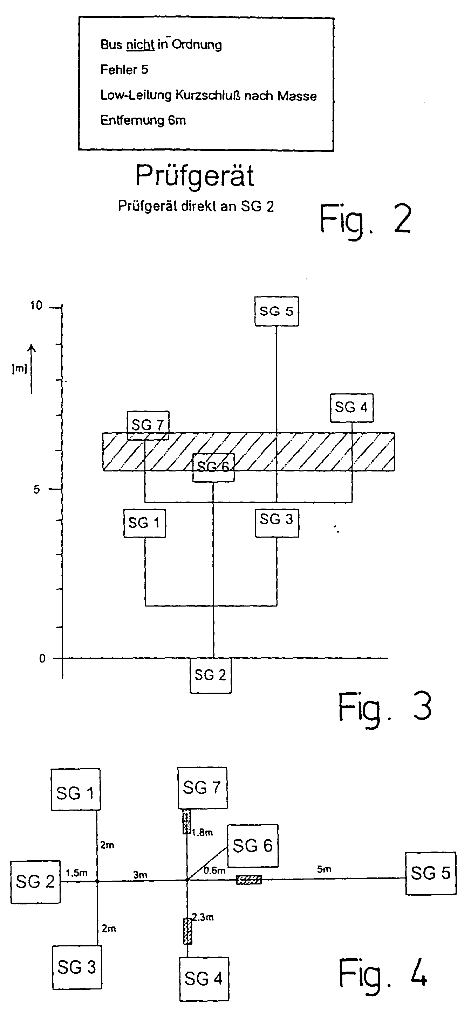

Die Figuren 2 bis 4 zeigen, wie aus der ermittelten Entfernung eines Fehlerortes von einem Prüfpunkt auf den Fehlerort im Netz geschlossen werden kann.

Figur 2 zeigt ein mögliches Display mit einer Fehlermeldung des Prüfgerätes. Aus der Entfernungsangabe kann beispielsweise in einem Diagramm entsprechend Figur 3 ein möglicher Fehlerort eingegrenzt werden. In einem nächsten Schritt kann entsprechend der Darstellung der Figur 4 der mögliche Fehlerort noch näher eingegrenzt werden, wenn ein Übergang zu der genauen Topologie des Netzes erfolgt. Beispielsweise mit einer Durchführung einer oder mehrerer weiterer Messungen an weiteren Orten kann der Fehlerort gegebenenfalls eindeutig bestimmt werden.

Das Netzdiagramm kann beispielsweise über einen Drucker in Papierform ausgegeben werden oder auf dem Display oder Bildschirm eines Computers angezeigt werden.

Erfindungsgemäß kann also durch den unter den Fehlerfällen bäufigsten Fall eines Kurzschlusses durch die lokale Eingrenzung ein erheblicher Aufwand bei der Lokalisierung des Fehlers vermieden werden.

## Patentansprüche

1. Verfahren zur Lokalisierung eines Kurzschluß oder Kabelbruchs in einem Bus-System, wobei das Bus-System an wenigstens einem Punkt mit einem Impuls einer solchen Steilheit beaufschlagt wird, daß sich an der Stelle des Kurzschluß bzw. des Kabelbruchs eine Reflexion einstellt und daß anhand der Laufzeit des Impulses eine Lokalisierung des Kurzschluß oder Kabelbruchs vorgenommen wird (1, 2),
dadurch gekennzeichnet, daß das Bus-System ein Zweidraht-Bus-System ist, das bei einem erkannten Kurzschluß nach Masse mit einem positiven Impuls beaufschlagt wird und bei einem erkannten Kurzschluß nach dem Netzpotential mit einem negativen Impuls (1).

2. Verfahren nach Anspruch 1,
dadurch gekennzeichnet, daß der Impuls zumindest näherungsweise ein Dirac-Stoß ist.

3. Schaltungsanordnung zur Durchführung eines der vorgenannten Verfahren, wobei ein Impulsgenerator (1) mit einer Gatterkette (2) mit Schieberegister verbunden ist, wobei mit der Aussendung eines Impulses auf das Zweidraht-Bus-System der Signaldurchlauf durch die Gatterkette (2) gestartet wird, wobei das reflektierte Signal den Signaldurchlauf durch die Gatterkette (2) abbricht, wobei aus der Anzahl der durchlaufenen Gatter die Entfernung des Kurzschlusses oder Kabelbruchs von dem Ort ermittelt wird, an dem der Impulsgenerator (1) an das Zweidraht-Bus-System angeschlossen ist, wobei von dem Impulsgenerator (1) bei einem erkannten Kurzschluß nach Masse ein positiver Impuls ausgesendet wird und bei einem erkannten Kurzschluß nach dem Netzpotential ein negativer Impuls.

4. Verfahren zur Lokalisierung eines Kabelbruches,
dadurch gekennzeichnet, daß auf einen Kabelbruch zu den Verbindungsleitungen eines Teilnehmers geschlossen wird, wenn dieser Teilnehmer bei der Kommunikation über den Bus nicht erreichbar ist.
